# FASCICULE DE BREVET EUROPEEN

(11) **EP 3 644 354 B1**
(45) Date de publication et mention de la délivrance du brevet: **12.02.2025**
(21) Numéro de dépôt: 19204086.3
(22) Date de dépôt: 18.10.2019
(51) Int. Cl.: H01L 23/373

(54) **INTERFACE DE DIFFUSION THERMIQUE**
SCHNITTSTELLE FÜR DIE THERMISCHE DIFFUSION
THERMAL DIFFUSION INTERFACE

(30) Priorité: 25.10.2018 FR 1801129
(43) Date de publication de la demande: 29.04.2020
(73) Titulaire: THALES, 92190 Meudon (FR)
(72) Inventeur: DENIS, Philippe, 78140 VELIZY VILLACOUBLAY (FR); GERFAULT, Bertrand, 78000 VERSAILLES (FR); BERTHELOT, Cécile, 78140 VELIZY VILLACOUBLAY (FR); SIERSDORFER, Alain, 74202 THONON LES BAINS CEDEX (FR)
(74) Mandataire: Atout PI Laplace

(56) Documents cités:
- CN-U- 202 134 529
- JP-A- 2007 234 904
- JP-A- 2014 093 143
- US-A1- 2003 056 938
- US-A1- 2005 013 119
- US-A1- 2014 034 282
- US-A1- 2018 158 747

## Description

La présente invention porte sur une interface de diffusion thermique, comme une semelle de boîtier de composant électronique ou un dissipateur de chaleur.

US 2005/013119 divulgue une interface de diffusion thermique en matériau à diffusion thermique isotrope, comprenant un insert en graphite en forme de croix.

La diffusion ou conduction thermique est un mode de transfert thermique provoqué par une différence de températures entre deux régions d'un même milieu, ou entre deux milieux en contact, et se réalisant sans déplacement global de matière (à l'échelle macroscopique) par opposition à la convection qui est un autre transfert thermique. Elle peut s'interpréter comme la transmission de proche en proche de l'agitation thermique: un atome ou une molécule cède une partie de son énergie cinétique à l'atome voisin.

Par exemple, dans le domaine des boîtiers de composants électroniques, les puces internes doivent dissiper une puissance très importante sur une surface très faible par exemple de quelques millimètres carrés.

Dans ce domaine, il est connu d'utiliser des boitiers en alliage Cu/Mo (Cuivre/Molybdène) ayant une conductivité thermique comprise entre 200 W.m⁻¹.K⁻¹ et 400 W.m⁻¹.K⁻¹ selon la proportion de Cu et de Mo.

Il est également connu d'utiliser de Cu/D (Cuivre/Diamant) avec des performances de conductivité de l'ordre de 500 W.m⁻¹.K⁻¹ mais dont le coût est de l'ordre de 60 fois plus important que la solution Cu/Mo.

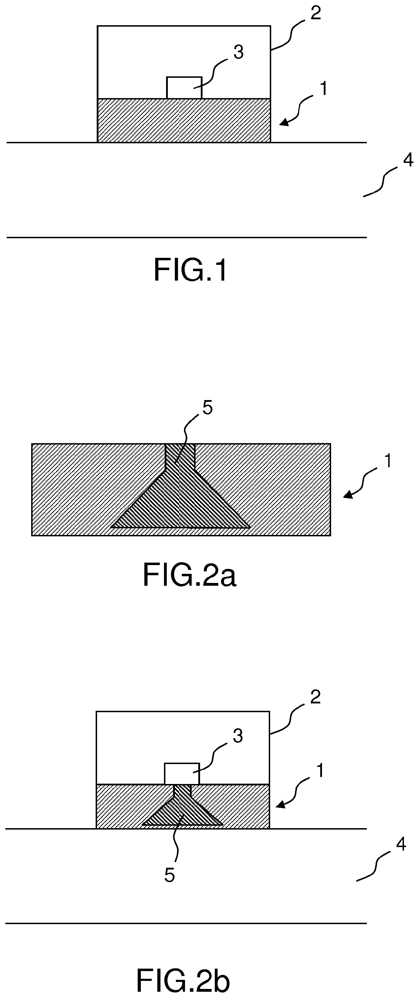

La figure 1 illustre schématiquement un exemple de réalisation d'interface de diffusion thermique 1 connue, en l'espèce une semelle 1 de boîtier 2 de composant électronique. En l'espèce la semelle 1 est en alliage Cu/Mo, et doit diffuser la puissance thermique ou chaleur fournie par une puce 3. La semelle 1 est fixée, par exemple par brasage, soudure ou collage à une structure 4, par exemple en aluminium Al d'un système tel un émetteur et/ou récepteur.

Un but de l'invention est de pallier les problèmes précédemment cités, et notamment de fournir une interface de diffusion thermique ayant une diffusion ou conductivité améliorée, à base de matériau facile à produire, et à coût réduit.

Il est proposé, selon un aspect de l'invention, une interface de diffusion thermique en matériau à diffusion thermique isotrope, comprenant un insert en matériau à diffusion thermique anisotrope comprenant du graphite comprenant au moins un plan privilégié de conduction thermique perpendiculaire au plan moyen de l'interface, la surface supérieure de l'insert débouchant sur la surface supérieure de l'interface, et la surface inférieure de l'insert étant recouverte par le matériau à diffusion thermique isotrope de l'interface ; l'insert étant en forme de croix avec une partie centrale surélevée correspondant à la surface supérieure de l'insert débouchant sur la surface supérieure de l'interface.

Le graphite, généralement fourni sous forme de barres ou feuilles, est anisotrope, et a une conduction thermique essentiellement dans les directions du plan moyen de la feuille et quasi nulle dans la direction orthogonale à ce plan moyen de la feuille. La présence d'un tel insert permet de diminuer la résistance thermique de la semelle et donc de limiter l'échauffement de l'élément monté en contact avec la partie supérieure de ce dernier, dont il faut dissiper la chaleur fournie.

La surface inférieure de l'insert est recouverte par le matériau à diffusion thermique isotrope de l'interface, ainsi on évite l'effritement du matériau à diffusion thermique anisotrope comprenant du graphite qui peut générer des pollutions, et ce dernier est protégé. En outre, la conduction thermique entre le matériau à diffusion thermique anisotrope comprenant du graphite et le matériau à diffusion thermique isotrope est améliorée car l'assemblage peut être réalisé par moulage.

Une telle forme d'insert permet de canaliser via sa composition en graphite le drainage de la chaleur de la source, pour ensuite favoriser la diffusion thermique dans le volume de la matrice. Il s'agit de profiter de la capacité de diffusion thermique importante du graphite, en cherchant à s'affranchir de son orthotropie à l'aide de la matrice isotrope. On peut alors améliorer la diffusion thermique dans la structure (insert+graphite) et de ce fait protéger les composants électroniques.

Dans un mode de réalisation, la surface inférieure de l'insert est plus grande que la surface supérieure de l'insert.

La zone origine de la puissance thermique définit la taille de la surface supérieure de l'insert, et la surface inférieure est déterminée pour maximiser la diffusion de cette puissance dans la matrice isotrope de l'interface de diffusion thermique, comme du cuivre ou un alliage Cu/Mo (Cuivre/Molybdène). Ceci permet d'utiliser au mieux les propriétés orthotropes du graphite, en limitant au maximum le besoin de diffusion dans la direction défavorable et en maximisant cette diffusion thermique dans le plan favorable, tout en favorisant l'échange de chaleur avec la matrice isotrope de l'interface de diffusion thermique.

Selon un mode de réalisation, le matériau à diffusion thermique isotrope comprend du cuivre.

Le cuivre est couramment utilisé dans les supports de composants électroniques pour ses propriétés de diffusion thermique alliées à sa facilité d'utilisation et son isotropie, et les propriétés du cuivre sont bien connues et maîtrisées.

Selon un mode de réalisation, la partie centrale surélevée a des bords inclinés d'un angle compris entre 30 et 60° par rapport à un axe perpendiculaire au plan moyen de l'interface, par exemple 45°.

De tels bords inclinés améliorent la diffusion de la chaleur de l'insert vers le reste de l'interface de diffusion thermique, et ce avec un optimum pour une inclinaison de 45°. L'inclinaison des bords permet d'améliorer la diffusion de chaleur en profitant d'une surface de contact plus grande entre le graphite et la matrice.

Par exemple, l'interface de diffusion thermique est configurée pour être une semelle de boîtier de composant électronique.

Par exemple, l'Interface de diffusion thermique est configurée pour être un dissipateur de chaleur, le principe étant de positionner l'élément pour lequel il faut dissiper de la chaleur en contact afin de bénéficier de l'échange thermique par conduction comme par exemple des radiateurs en aluminium sur des puces ou des transistors de puissance.

Dans un mode de réalisation, la surface supérieure de l'insert est inférieure à celle de la surface de l'élément délivrant de la chaleur, destinée à être en contact avec ladite surface supérieure de l'insert.

Ainsi, on améliore la diffusion de chaleur en profitant d'une surface de contact plus grande avec la matrice en cuivre.

L'invention sera mieux comprise à l'étude de quelques modes de réalisation décrits à titre d'exemples nullement limitatifs et illustrés par les dessins annexés sur lesquels :
- la figure 1 illustre schématiquement, un exemple de réalisation d'interface de diffusion thermique connue, en l'espèce une semelle 1 de boîtier 2 de composant électronique selon l'état de la technique ;
- la figure 2a illustre schématiquement une interface de diffusion thermique selon un aspect de l'invention ;
- la figure 2b illustre schématiquement une interface de diffusion thermique, configurée pour être une semelle de boîtier de composant électronique, selon un aspect de l'invention ; et
- la figure 3 illustre schématiquement un insert en graphite en forme de croix, selon un aspect de l'invention ;
- la figure 4 illustre schématiquement une pluralité d'inserts en graphite en forme de barres, en l'espèce quatre, selon un aspect de l'invention ; et
- la figure 5 illustre schématiquement une interface de diffusion thermique comprenant une pluralité, en l'espèce quatre, inserts en graphite en forme de barres, selon la figure 4, selon un aspect de l'invention.

Sur l'ensemble des figures, les éléments ayant des références identiques sont similaires.

Dans la présente description, les modes de réalisation décrits sont nullement limitatifs, et les caractéristiques et fonctions bien connues de l'homme du métier ne sont pas décrites en détails.

La figure 2a représente schématiquement une interface de diffusion thermique 1 avec un insert en graphite 5, selon un aspect de l'invention. L'insert en graphite 5 comprend au moins un plan privilégié de conduction thermique perpendiculaire au plan moyen de l'interface 1, la surface supérieure de l'insert 5 débouchant sur la surface supérieure de l'interface 1, et la surface inférieure 5a de l'insert 5 étant recouverte par le matériau à diffusion thermique isotrope de l'interface 1.

La conduction thermique du graphite dans un plan privilégié de conduction thermique perpendiculaire au plan moyen de l'interface 1 est primordiale. Elle peut être assurée lors de la fabrication du graphite par un recuit à très haute température qui permet d'obtenir une conduction de l'ordre de 1000 W.m⁻¹K⁻¹.

Le matériau à diffusion thermique isotrope est préférentiellement à base de cuivre Cu, car il présente une valeur de conductivité thermique assez élevée, et son utilisation dans le domaine de l'électronique et de la diffusion thermique est bien connue.

Le processus d'intégration de l'insert 5 en graphite pyrolytique dans le matériau à diffusion thermique isotrope comme le cuivre Cu consiste à enrober dans un four du cuivre porté à sa température de fusion dans un moule en graphite par exemple. Après refroidissement du cuivre, l'insert en graphite est enrobé dans le cuivre et repris par exemple de manière mécanique pour avoir une surface de contact optimale d'un coté en surfaçant le cuivre et de l'autre en faisant apparaître la partie active de l'insert 5.

Sur la figure 2b est représentée schématiquement une interface de diffusion thermique 1 dans un exemple de réalisation d'interface de diffusion thermique 1 connue, en l'espèce une semelle 1 de boîtier 2 de composant électronique. En l'espèce, la semelle 1 comprend du cuivre Cu, et l'insert en graphite 5 doit diffuser la puissance thermique ou chaleur fournie par une puce 3. La semelle 1 est fixée, par exemple par brasage, soudure ou collage, à une structure 4, par exemple en aluminium Al d'un système tel un émetteur et/ou récepteur.

La surface inférieure 5a de l'insert peut être plus grande que la surface supérieure de l'insert, pour maximiser l'échange thermique entre le graphite et sa matrice en cuivre.

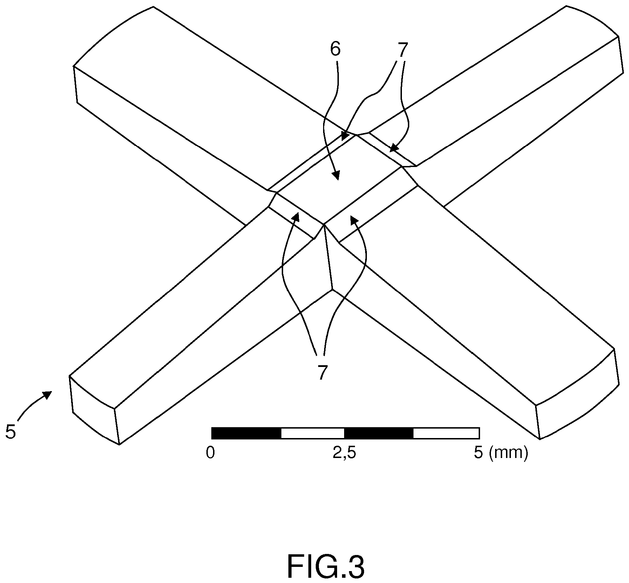

La figure 3 représente schématiquement un insert 5 en graphite en forme de croix avec une partie centrale surélevée 6 correspondant à la surface supérieure de l'insert 5 débouchant sur la surface supérieure de l'interface 1.

En raison de la forte orthogonalité de la conductivité thermique du graphite, une forme en croix est déterminée pour permettre une meilleure dissipation du flux thermique dans l'enrobage de cuivre.

La partie centrale surélevée 6 de l'insert en graphite 5 a des bords 7 inclinés d'un angle compris entre 30 et 60° par rapport à un axe perpendiculaire au plan moyen de l'interface, idéalement de 45°. Cela permet d'avoir la surface d'échange la plus importante de graphite avec le cuivre.

En variante, l'interface de diffusion thermique peut être un dissipateur de chaleur, tel des doigts ou tout autre moyens permettant d'augmenter la surface d'échange thermique entre le graphite et le cuivre.

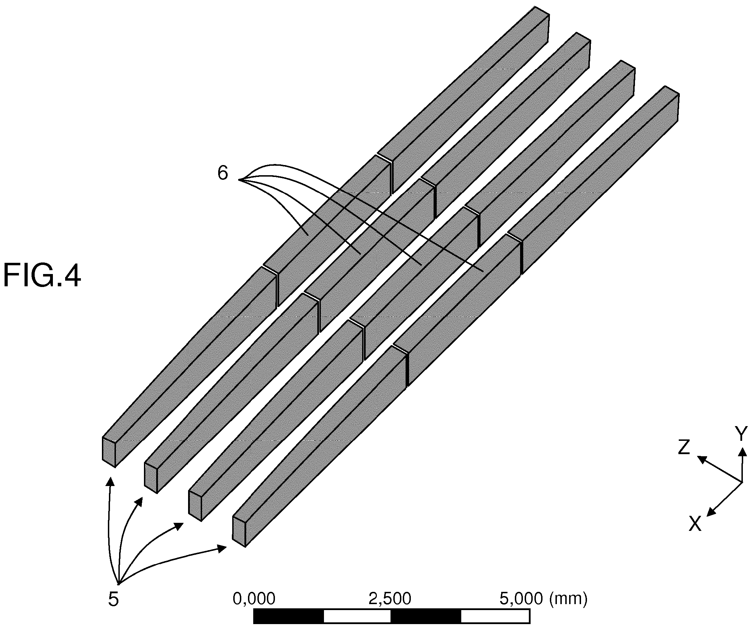

La figure 4 représente schématiquement une pluralité d'inserts 5 en graphite, en l'espèce 4, en forme de barres parallèles, avec une partie centrale surélevée 6 correspondant à la surface supérieure de l'insert 5 débouchant sur la surface supérieure de l'interface 1.

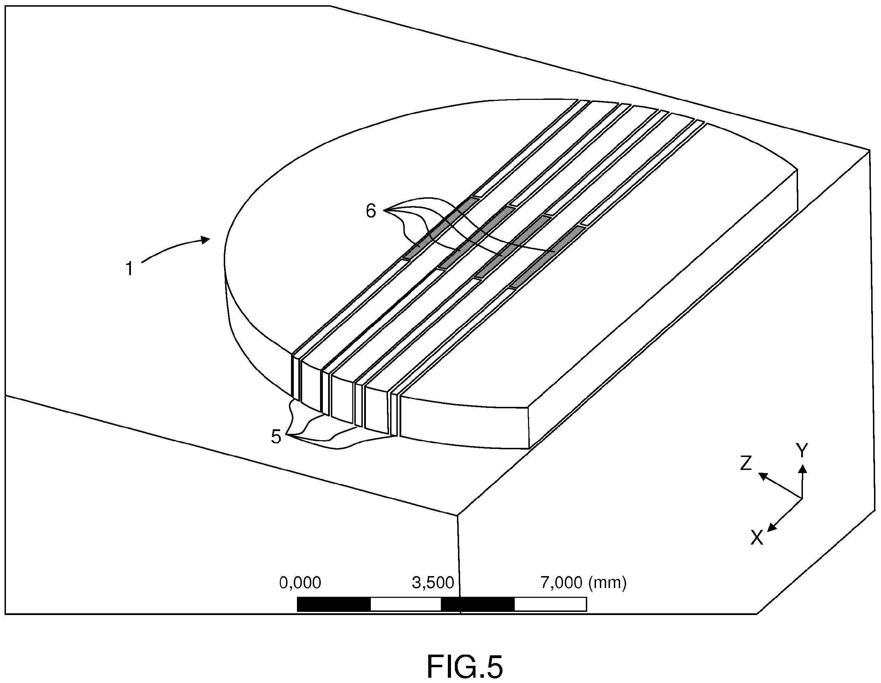

La figure 5 illustre schématiquement une interface de diffusion thermique 1 comprenant une pluralité, en l'espèce quatre, inserts en graphite en forme de barres, selon la figure 4, selon un aspect de l'invention.

L'anisotropie thermique du graphite diminue la conduction de la chaleur perpendiculairement au plan (x,y) de la feuille de graphite de l'insert. Cette propriété permet de limiter les échanges thermiques entre deux éléments fournissant de la chaleur, comme des composants électroniques telles des puces hyperfréquences, placés l'un à côté de l'autre sur l'axe z sur deux inserts disjoints.

En hyperfréquence, on cherche à rapprocher les puces pour limiter les éléments parasites telles les inductances. Mais la diffusion inter-puces avec un matériau à diffusion thermique isotrope limite ce rapprochement et donc la fréquence maximale de fonctionnement. Avec les inserts des figures 4 et 5 en matériau à diffusion thermique anisotropes comprenant du graphite, il est possible de diminuer cette conduction et donc de rapprocher les puces et augmenter la fréquence maximale de fonctionnement du circuit hyperfréquence.

## Revendications

1. Interface de diffusion thermique (1) en matériau à diffusion thermique isotrope, comprenant un insert (5) en matériau à diffusion thermique anisotrope comprenant du graphite comprenant au moins un plan privilégié de conduction thermique perpendiculaire au plan moyen de l'interface (1), la surface supérieure de l'insert (5) débouchant sur la surface supérieure de l'interface (1), et la surface inférieure (5a) de l'insert (5) étant recouverte par le matériau à diffusion thermique isotrope de l'interface (1) ; l'insert (5) étant en forme de croix avec une partie centrale (6) surélevée correspondant à la surface supérieure de l'insert (5) débouchant sur la surface supérieure de l'interface (1).

2. Interface de diffusion thermique (1) selon la revendication 1, dans laquelle la surface inférieure (5a) de l'insert (5) est plus grande que la surface supérieure de l'insert (5).

3. Interface de diffusion thermique (1) selon l'une des revendications précédentes, dans laquelle le matériau à diffusion thermique isotrope comprend du cuivre.

4. Interface de diffusion thermique (1) selon l'une des revendications précédentes, dans laquelle la partie centrale surélevée (6) a des bords (7) inclinés d'un angle compris entre 30 et 60° par rapport à un axe perpendiculaire au plan moyen de l'interface (1).

5. Interface de diffusion thermique (1) selon la revendication 4, dans laquelle la partie centrale surélevée (6) a des bords (7) inclinés d'un angle de 45° par rapport à un axe perpendiculaire au plan moyen de l'interface (1).

6. Interface de diffusion thermique (1) selon l'une des revendications 1 à 5, configurée pour être une semelle de boîtier de composant électronique.

7. Interface de diffusion thermique (1) selon l'une des revendications 1 à 5, configurée pour être un dissipateur de chaleur.

8. Interface de diffusion thermique (1) selon l'une des revendications précédentes, dans laquelle la surface supérieure de l'insert (5) est inférieure à celle de la surface de l'élément délivrant de la chaleur, destinée à être en contact avec ladite surface supérieure de l'insert (5).

## Patentansprüche

1. Thermodiffusionsschnittstelle (1) aus einem isotropen Thermodiffusionsmaterial, umfassend einen Einsatz (5) aus einem anisotropen Thermodiffusionsmaterial, umfassend Graphit, umfassend mindestens eine vorrangige Wärmeleitungsebene senkrecht zur Mittelebene der Schnittstelle (1), wobei die obere Oberfläche des Einsatzes (5) auf der oberen Oberfläche der Schnittstelle (1) mündet und die untere Oberfläche (5a) des Einsatzes (5) von dem isotropen Thermodiffusionsmaterial der Schnittstelle (1) bedeckt ist; wobei der Einsatz (5) in Kreuzform vorliegt, wobei ein mittlerer Teil (6), der der oberen Oberfläche des Einsatzes (5) entspricht, auf der oberen Oberfläche der Schnittstelle (1) mündet.

2. Thermodiffusionsschnittstelle (1) nach Anspruch 1, wobei die untere Oberfläche (5a) des Einsatzes (5) größer als die obere Oberfläche des Einsatzes (5) ist.

3. Thermodiffusionsschnittstelle (1) nach einem der vorhergehenden Ansprüche, wobei das isotrope Thermodiffusionsmaterial Kupfer umfasst.

4. Thermodiffusionsschnittstelle (1) nach einem der vorhergehenden Ansprüche, wobei der mittlere erhöhte Teil (6) Ränder (7) aufweist, die um einen Winkel zwischen 30 und 60° in Bezug auf eine Achse senkrecht zur Mittelebene der Schnittstelle (1) geneigt sind.

5. Thermodiffusionsschnittstelle (1) nach Anspruch 4, wobei der mittlere erhöhte Teil (6) Ränder (7) aufweist, die um einen Winkel von 45° in Bezug auf eine Achse senkrecht zur Mittelebene der Schnittstelle (1) geneigt sind.

6. Thermodiffusionsschnittstelle (1) nach einem der Ansprüche 1 bis 5, die dafür konfiguriert ist, eine Gehäusebodenplatte eines elektronischen Bauteils zu sein.

7. Thermodiffusionsschnittstelle (1) nach einem der Ansprüche 1 bis 5, die dafür konfiguriert ist, ein Wärmeableiter zu sein.

8. Thermodiffusionsschnittstelle (1) nach einem der vorhergehenden Ansprüche, wobei die obere Oberfläche des Einsatzes (5) kleiner als diejenige der Oberfläche des Elements ist, das Wärme liefert, die dafür gedacht ist, mit der oberen Oberfläche des Einsatzes (5) in Kontakt zu stehen.

## Claims

1. Thermal diffusion interface (1) made from a material with isotropic thermal diffusion, comprising an insert (5) made from a material with anisotropic thermal diffusion comprising graphite comprising at least one favoured plane of thermal conduction perpendicular to the mean plane of the interface (1), the upper surface of the insert (5) opening onto the upper surface of the interface (1), and the lower surface (5a) of the insert (5) being covered with the isotropic thermal diffusion material of the interface (1); the insert (5) being in the shape of a cross with a raised central part (6) corresponding to the upper surface of the insert (5) opening onto the upper surface of the interface (1).

2. Thermal diffusion interface (1) according to claim 1, wherein the lower surface (5a) of the insert (5) is larger than the upper surface of the insert (5).

3. Thermal diffusion interface (1) according to one of the preceding claims, wherein the isotropic thermal diffusion material comprises copper.

4. Thermal diffusion interface (1) according to one of the preceding claims, wherein the raised central part (6) has edges (7) inclined by an angle between 30 and 60° with respect to an axis perpendicular to the mean plane of the interface (1).

5. Thermal diffusion interface (1) according to claim 4, wherein the raised central part (6) has edges (7) inclined by an angle of 45° with respect to an axis perpendicular to the mean plane of the interface (1).

6. Thermal diffusion interface (1) according to one of claims 1 to 5, configured to be a base of a housing of an electronic component.

7. Thermal diffusion interface (1) according to one of claims 1 to 5, configured to be a heat sink.

8. Thermal diffusion interface (1) according to one of the preceding claims, wherein the upper surface of the insert (5) is smaller than that of the surface of the element delivering the heat, which is intended to be in contact with said upper surface of the insert (5).
